# EUROPEAN PATENT APPLICATION

(11) **EP 4 360 860 A1**
(43) Date of publication of application: **01.05.2024**
(21) Application number: 23196393.5
(22) Date of filing: 08.09.2023
(51) Int. Cl.: B29D 11/00

(54) **A DIE INCLUDING A NON-RECTANGULAR SHAPED OPTICAL MATERIAL AND METHODS OF MANUFACTURE**

(30) Priority: 24.10.2022 US 202217972453
(71) Applicant: Viavi Solutions Inc., Chandler, AZ 85286 (US)
(72) Inventor: Buth, Joerg, California, 95401 (US); Zieba, Jaroslaw, California, 95405 (US); Ward, Bradley John, New York, 14534 (US); Sales, Tasso R.M., New York, 14623 (US)
(74) Representative: Murgitroyd & Company

(57) **Abstract**

A die including a substrate having a surface defined by paired oppositely-oriented edges; and an optical material, in a non-rectangular shape, and on the surface of the substrate; wherein the optical material does not extend an entire length of any one of the paired oppositely-oriented edges is disclosed. A wafer can including a plurality of the dies. Methods of making the wafer and the die are also disclosed.

## Description

### FIELD OF THE INVENTION

The present disclosure generally relates to a die including a substrate having a surface defined by paired oppositely-oriented edges; and an optical material, in a non-rectangular shape, and on the surface of the substrate; wherein the optical material does not extend an entire length of any one of the paired oppositely-oriented edges. A wafer can include a plurality of the dies. Methods of making the wafer and the die are also disclosed.

### BACKGROUND OF THE INVENTION

Current die-size light diffusers are made of a single, large polymer layer on a, in most cases round shaped, rigid optical quality substrate. The wafer is then generally diced along dicing lines, which are parallel vertical and horizontal grid lines, to form a plurality of dies. In this manner, each die is a rectangular-shaped (or square-shaped, if the sides are equal in dimension) polymer on glass.

It has been noticed that during the dicing of the wafer into the dies, the corners and edges of the dies can exhibit various defects. These defects can include glass chips, voids, and dicing-induced delamination at the polymer/glass interface, etc. These defects can cause failure of the die during repeated thermal cycling, and/or failure to satisfy thermal shock reliability specifications.

Additionally, when using the rectangular-shaped die, it is only the center region that is being effectively used because most incident light beams are circular. Even with the largest beam sizes passing through a diffuser, the corners and a majority of the edges of the die are outside of the actively used area. It is these areas, i.e., the corners and the majority of the edges, that are optically redundant and contribute to the formation of defects.

What is needed is an article, such as a die and/or wafer, that does not exhibit the defects discussed above and can pass repeated thermal cycling and/or thermal shock reliability. Additionally, the die can include a non-rectangular shaped material with a dimension that can be adjusted to accommodate a size of an incident beam from a light source.

### BRIEF DESCRIPTION OF THE DRAWINGS

Features of the present disclosure are illustrated by way of example and not limited in the following figure(s), in which like numerals indicate like elements, in which:
FIG. 1 illustrates a wafer according to an aspect of the invention;
FIG. 2A illustrates a top view of a die according to an aspect of the invention;
FIG. 2B illustrates a cross-section of the die of FIG. 2A;
FIG.3 illustrates a plurality of dies with two or more non-rectangular shapes of optical material;
FIGs. 4A and 4B illustrate a comparative wafer;
FIG. 5A illustrates a top view of a comparative die;
FIG. 5B illustrates a cross-section of the comparative die of FIG. 5A;
FIG. 6A illustrates a top view of a die waste cut from the comparative wafer of FIG. 4;
FIG. 6B illustrates a cross-section of the comparative die waste cut of FIG. 6A; and
FIG. 7 illustrates a system including a light source and a die, according to an aspect of the invention.

### SUMMARY OF THE INVENTION

In a first aspect, there is disclosed a die comprising: a substrate having a surface defined by paired oppositely-oriented edges; and an optical material, in a non-rectangular shape, and on the surface of the substrate; wherein the optical material does not extend an entire length of any one of the paired oppositely-oriented edges.

In a second aspect, there is disclosed a wafer comprising: a plurality of dies in accordance with the first aspect, wherein the plurality of dies share a common continuous surface of the substrate. In a third aspect, there is disclosed a method of making a wafer (e.g. the wafer of the second aspect), comprising: placing an optical material on a portion of a mold having a positive relief pattern to form a non-rectangular shape of optical material on each positive relief of the pattern; contacting a substrate with the optical material to provide a non-rectangular shaped to the optical material having a thickness ranging from about 20 micron to about 200 microns; and removing the mold.

In a fourth aspect, there is disclosed a method of making a die (e.g. a die of the first aspect), comprising: providing a wafer (e.g. the wafer of the second aspect), and dicing the wafer between separate portions of the optical material.

Additional features and advantages of various embodiments will be set forth, in part, in the description that follows, and will, in part, be apparent from the description, or can be learned by the practice of various embodiments. The objectives and other advantages of various embodiments will be realized and attained by means of the elements and combinations particularly pointed out in the description herein.

### DETAILED DESCRIPTION OF THE INVENTION

For simplicity and illustrative purposes, the present disclosure is described by referring mainly to an example thereof. In the following description, numerous specific details are set forth in order to provide a thorough understanding of the present disclosure. It will be readily apparent however, that the present disclosure may be practiced without limitation to these specific details. In other instances, some methods and structures have not been described in detail so as not to unnecessarily obscure the present disclosure.

Additionally, the elements depicted in the accompanying figures may include additional components and some of the components described in those figures may be removed and/or modified without departing from scopes of the present disclosure. Further, the elements depicted in the figures may not be drawn to scale and thus, the elements may have sizes and/or configurations that differ from those shown in the figures.

It is to be understood that both the foregoing general description and the following detailed description are exemplary and explanatory only, and are intended to provide an explanation of various embodiments of the present teachings. In its broad and varied embodiments, disclosed herein is a die 28, a wafer 26, and methods of making a die 28 and a wafer 26. The die 28 can comprise a substrate 10 having a surface defined by paired oppositely-oriented edges; and an optical material 12, in a non-rectangular shape, on a surface of the substrate 10. The optical material 12 does not extend an entire length of any one of the paired oppositely-oriented edges of the substrate 10.

Dicing a wafer 26 into a plurality of dies 28 having an optical material 12, in a non-rectangular shape, can result in minimal defects. The less defects present in a die 28 can also result in a reduction in delamination at the interface 22 of the optical material 12 and the substrate 10. By reducing or eliminating these defects on the die 28, the dies 28 should be able to exhibit improved thermal shock reliability and improved performance during thermal cycling.

Additionally, the non-rectangular shape of the optical material 12 can be designed to match a cross-section of an incident beam 32, such as from a light source 30, and a light shaping optical element (e.g., a diffuser). In this manner, the die 28 can have improved space utilization and reduced physical dimensions.

In addition, the method of making a wafer 26 and/or die 26 can exhibit improved efficiency because the non-rectangular shape corresponds to the way the optical material 12 is deposited during the replication process. In this manner, the optical material 12 can be applied with increased thickness and dimensional accuracy resulting in reduced costs for optical material 12.

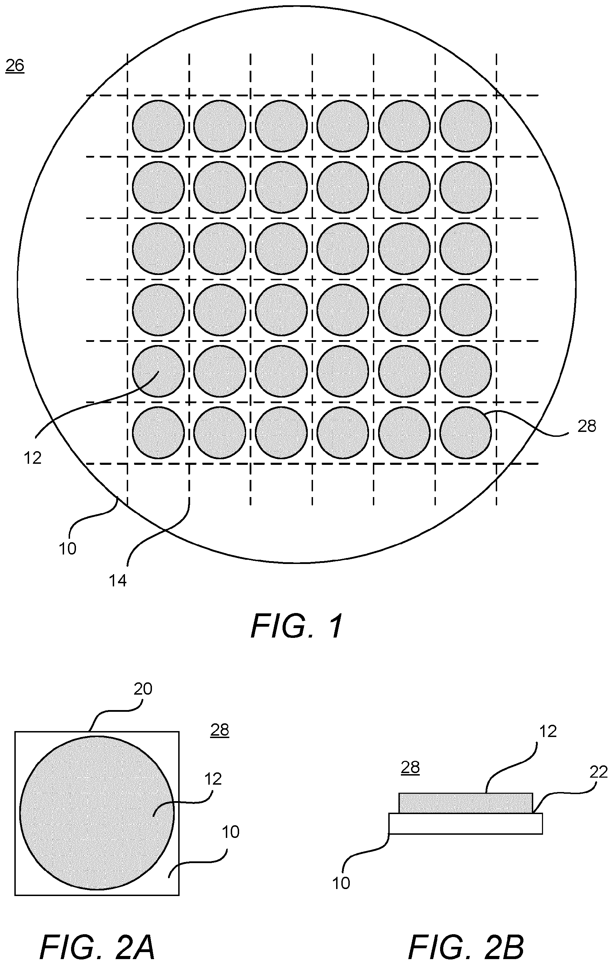

FIG. 1 illustrates a wafer 26 including a plurality of dies 28. The plurality of dies 28 share a common continuous surface of a substrate 10. The dies 28 can be separated one from another by a substrate only area, e.g., dicing street 14. The dicing street 14 can be an imaginary line extending between two or more dies 28 and can be a guide for dicing the wafer 26. The dicing street 14 can be a plurality of parallel horizontal and vertical lines forming a grid pattern. A wafer 26 can be diced along the dicing street 14 to produce two or more dies 28, and optionally a die waste-cut 24, or a piece of substrate 10 without any optical material 12. For example, in FIG. 1, row 1 and column 1 can be areas of substrate 10 without (void of) any optical material 12.

The substrate 10 can be a round wafer or, in special cases, a square one. It is a material, optically transparent in the desired spectral region, such as glass, semiconductor materials, ceramic materials, and polymers. In an aspect, the substrate 10 is glass. The substrate 10 can have a size ranging in diameter from about 100 mm to about 300 mm, or, if square in shape, about 50 mm x about 50 mm to about 300 mm x about 300 mm. In a majority of cases, the thickness of the substrate ranges from about 0.2 mm to about 1.0 mm. At a die level, the substrate 10 can have a size ranging from about 0.5 mm x about 0.5 mm to about 50 mm x about 50 mm. The size of the substrate 10 can be dependent upon a customer's specification, and can be defined by a first dimension (e.g., a length) and a second dimension (e.g., a width). At die level, the substrate 10 can have an aspect ratio ranging from about 1:1 to about 10:1 (length to width). The substrate 10 can have a surface, such as a top surface, defined by paired oppositely-oriented edges 20. In this manner, the substrate 10 can be a rectangle or a square.

FIGs. 2A and 2B illustrate a die 28 that has been formed when the wafer 26 of FIG. 1 is diced along the dicing streets 14. The die 28 can comprise a substrate 10 having a surface defined by paired oppositely-oriented edges 20; and an optical material 12, in a non-rectangular shape, and on the surface of the substrate 10; wherein the optical material 12 does not extend an entire length of any one of the paired oppositely-oriented edges 20. As shown in FIG. 2A, the optical material 12 can be a single non-rectangular shape on the surface of the substrate 10. As shown in FIG. 2B, the optical material 12 does not extend an entire length of any one of the paired oppositely-oriented edges. In an aspect, a portion, near an edge 22, of the top surface of the substrate 10 can be void of optical material 12. In this manner, there is a decreased likelihood that a defect will occur at an interface 22 of the optical material 12 and the substrate 10 during dicing.

The optical material 12 can include optical quality media chosen from UV curable polymers, organic/inorganic host-guest systems, and organic/inorganic hybrid systems. Non-limiting examples of UV curable polymers include free-radical cure acrylates, cationic cure epoxies, UV cross-linkable polymers, and heat cross-linkable polymers. The organic/inorganic host-guest systems can utilize dispersions of nanoparticles of various materials to set a refractive index at a desired level. The organic/inorganic hybrid systems can include sol-gels, ormosils, and polymeric glass-like materials. In an aspect, the optical material 12 can be chosen from a polymer and a sol-gel.

The optical material 12 can be present in a non-rectangular shape so that a planar bottom surface interfaces with a top surface of the substrate 10. The optical material 12 can have one or more surfaces that, together, with the planar bottom surface, form a three-dimensional shape selected from the group consisting of pyramid, pentagon prism, hexagon prism, septagon prism, octagon prism, a half-sphere, cylinder, and a cone. The non-rectangular shape of the optical material 12 can be selected based upon a shape of an incident beam 32 from a light source 30.

As shown in FIGs. 2A and 2B, the planar bottom surface of the optical material 12 can cover a majority, but less than an entirety, of the top surface of the substrate 10. As used herein, a "majority" is understood to mean greater than 50%. In an aspect, the optical material 12 covers from greater than 50% to less than 100% of the top surface of the substrate 10; for example, greater than 55% to less than or equal to 95%; and as a further example, greater than 65% to less than or equal to 90%. In another aspect, the optical material 12 does not extend to one or more edges 20 or corners of the substrate 10. In this manner, the cost of the optical material 12 can be reduced, and the likelihood of formation of defects due to dicing can be reduced.

In an aspect, the optical material 12 is a non-rectangular shape, such as a cylinder. A diameter of the cylinder is equal to a first dimension of the substrate 10. In another aspect, a diameter of the cylinder is less than a first dimension of the substrate 10. A first dimension of the substrate 10 can be a length or a width. For example, the optical material 12 can be present in a size ranging from equal to a first dimension of the substrate 10 to 5% of the first dimension of the substrate 10. The non-rectangular shape of the optical material 12 can be sized to match a size of an incident beam 32.

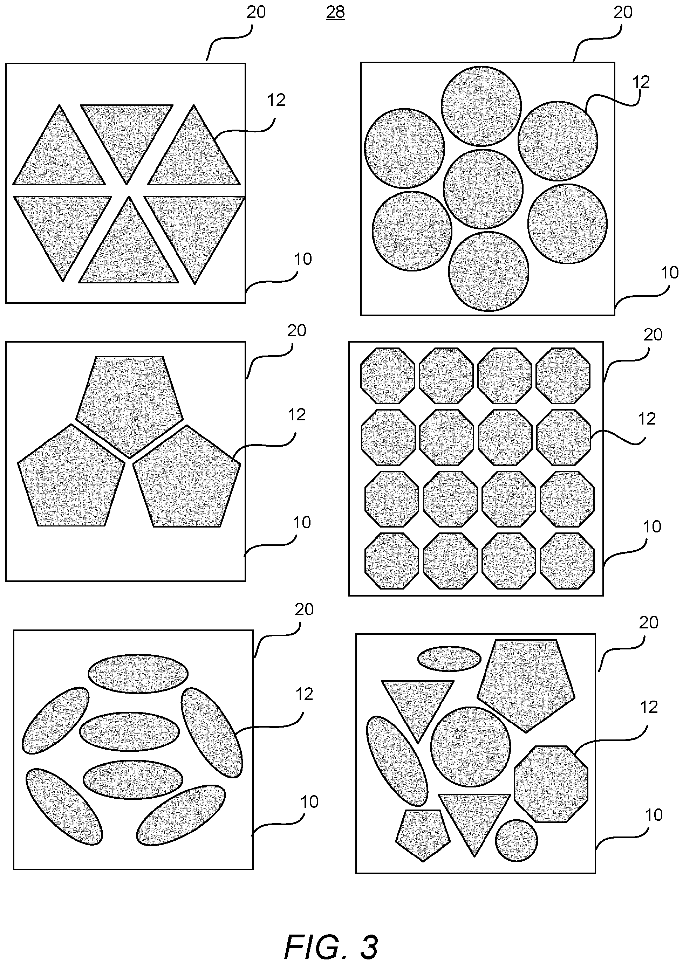

As shown in FIG. 3, the die 28 can include an optical material 12 present in two or more non-rectangular shapes on the surface of the substrate 10. The two or more non-rectangular shapes can be separated one from another by a gap in the optical material 12. These gaps can be a substrate 10 only area. The two or more non-rectangular shapes can be the same shape or they can be a combination of different shapes. In an aspect, the two or more non-rectangular shapes, of the optical material 12, ranges from about 2 to about 10 non-rectangular shapes of optical material in a die 28.

In an aspect, the optical material 12 can be present on the substrate 10 in a non-uniform thickness. A top surface of the optical material 12 can include microstructures or a diffraction grating. In this aspect, a thickness of the optical material can include two components, i.e., a base line thickness and a nominal thickness. A base line thickness of the optical material 12 can range from about 0 to about 500 microns, for example, from about 0.5 to about 480 microns, and as a further example, from about 5 to about 450 microns. A nominal thickness of the optical material can include the base line thickness and a height of the microstructures or diffraction grating. The nominal thickness can range from about 5 to about 1000 microns; for example, from about 10 to about 900 microns; and as a further example from about 20 to about 200 microns.

The values for the base line thickness and the nominal thickness can be determined by a few variables, such as a refractive index of the substrate 10 at selected wavelengths, a refractive index of the optical medium used to create the light shaping optical elements such as optical diffusers, gratings, lenses, waveguides, prisms, etc. The values can also be determined based upon a need to control the mechanical stress between the optical material 12 and substrate 10, and the specific optical functionality of the optical material 12.

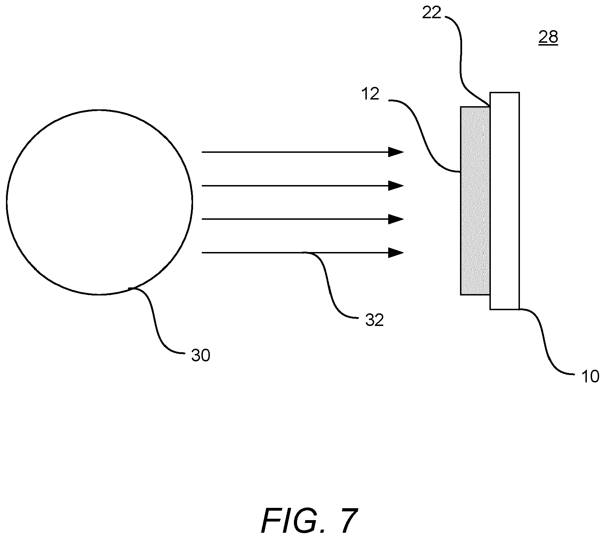

There is also disclosed a system including a light source 30 emitting an incident beam 32 that can be received by the die 28, as shown in FIG. 7.

There is also disclosed a method of making a wafer 26, including placing an optical material 12 on a portion of a mold having a positive relief pattern to form a non-rectangular shape of optical material 12 on each positive relief of the pattern; contacting a substrate 10 with the optical material 12 to provide a non-rectangular shape to the optical material 12 having a thickness ranging from about 5 micron to about 1000 microns; and removing the mold. Due to the natural flow dynamics of liquids, allowing round shaped optical material 12 droplets to spread allows for controlling a diameter and thickness of the optical material 12. In particular, the step of placing the optical material 12 can include controlling a droplet size of the optical material 12.

A method of making a die 28 can include providing the wafer 26; and dicing the wafer 28, such as along one or more dicing streets 14, between separate portions of the optical material 12. In an aspect, the dicing streets 14 can be substrate 10 only area, i.e., are void of optical material 12.

### EXAMPLES

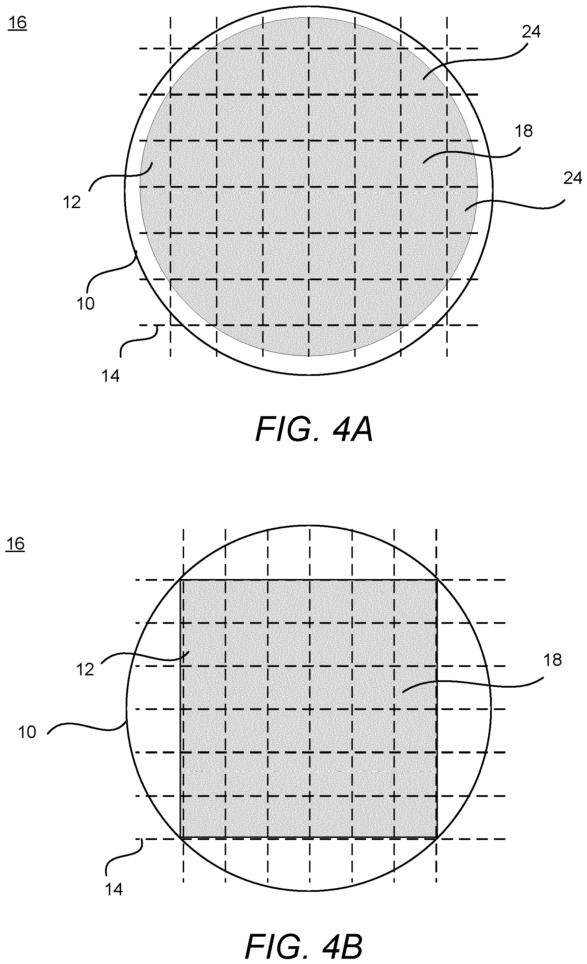

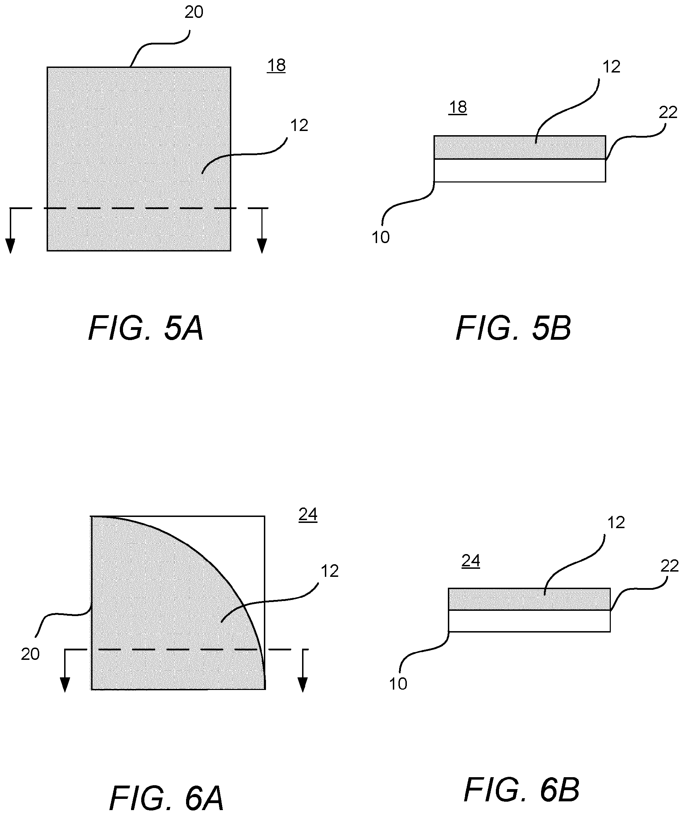

COMPARATIVE EXAMPLE 1 - A conventional wafer 16 is shown in FIGs. 4A and 4B. The wafer 16 includes a circular-shaped substrate 10, which is generally glass. An optical material 12, such as a polymer, was deposited on the substrate 10. During a manufacturing process, the wafer 16 was diced along dicing streets 14, which are parallel horizontal and vertical grid lines. The dicing produced a plurality of dies 18, which were formed based upon a customer's specification, and a plurality of die waste cuts 24, which did not meet the customer's specification. As shown in FIGs. 5A and 5B, the die 18 was a rectangular-shaped optical material 12 that extended an entire length of each edge 20 (i.e., there are four edges to the rectangle) of the substrate 10. The die 18 exhibited defects, such as glass chips, voids, and dicing-induced delamination, during repeated thermal cycling.

The die waste cuts 24 were not considered dies 18 by the skilled artisan for various reasons, such as they did not meet a customer's specification, could have polymer disuniformity, and/or defects formed at an interface 22 with the optical material 12 and the substrate 10, etc. Referring to FIG. 4A, and using the dicing street 14 as a reference, the die waste cuts 24 would include the entire top row and bottom row, the entire left column and right column, as well as the area at row 2, columns 2 and 7; row 2, columns 1and 8, etc. Referring to FIG. 4B, there are no die waste-cuts because the dicing lines 14 were placed to optimize the shape of the optical material 12 on the substrate 10. As shown in FIGs. 6A and 6B, the die waste cut 24 includes a substrate 10 having a surface defined by paired oppositely-oriented edges 20; and a non-rectangular shaped optical material 12 on the surface of the substrate 10; wherein the non-rectangular shape of the optical material 12 extends an entire length of any one of the paired oppositely-oriented edges 20. For ease of understanding, in FIGs. 6A and 6B, the non-rectangular shaped optical material 12 extends an entire length of the left side and the bottom side of edges 20 of the substrate 10. Defects also form at the interface 22 with the optical material 12 and the substrate 10 due to the dicing and thermal cycling.

EXAMPLE 1 - A wafer 26, as disclosed herein, is shown in FIG. 1. The wafer 26 includes a round (preferably) (or square) shaped substrate 10, which is generally glass. An optical material 12, such as a polymer, was deposited on the substrate 10. During a manufacturing process, the wafer 26 was diced along dicing streets 14, which are parallel horizontal and vertical grid lines. The dicing produced a plurality of dies 28, as disclosed herein, which were formed based upon a customer's specification. As shown in FIGs. 2A and 2B, the die 28 included a substrate 10 having a surface defined by paired oppositely-oriented edges 20; and a non-rectangular shaped optical material 12 on the surface of the substrate 10; wherein the non-rectangular shaped optical material 12 does not extend an entire length of any one of the paired oppositely-oriented edges 20. The die 28 did not exhibit defects, such as glass chips, voids, and dicing-induced delamination, on the glass-optical layer interface 22 as a result of either the dicing process itself or after repeated thermal cycling.

The present disclosure is directed to a die 1.1 comprising: a substrate having a surface defined by paired oppositely-oriented edges; and an optical material, in a non-rectangular shape, on the surface of the substrate; wherein the optical material does not extend an entire length of any one of the paired oppositely-oriented edges.
1.2 The die of 1.1, wherein the optical material, in the non-rectangular shape, has a planar bottom surface that interfaces with a top surface of the substrate; and has one or more surfaces that, together with the planar bottom surface, form a three-dimensional shape selected from the group consisting of a pyramid, pentagon prism, hexagon prism, septagon prism, octagon prism, a half-sphere, cylinder, and cone.
1.3 The die of 1.2, wherein the planar bottom surface of the optical material covers a majority, but less than an entirety, of the top surface of the substrate.
1.4 The die of 1.1, wherein the non-rectangular shape of the optical material is a cylinder.
1.5 The die of 1.4, wherein a diameter of the cylinder is equal to a first dimension of the substrate.
1.6 The die of 1.4, wherein a diameter of the cylinder is less than a first dimension of the substrate.
1.7 The die of 1.0, wherein the optical material is a single non-rectangular shape on the surface of the substrate.
1.8 The die of 1.0, wherein the optical material is two or more non-rectangular shapes on the surface of the substrate, and the two or more non-rectangular shapes are separated one from another by a gap in the optical material.
1.9 The die of 1.0, wherein a portion, near an edge, of the top surface of the substrate is void of the optical material.
1.10 The die of 1.0, wherein the optical material has a non-uniform thickness.
1.11 The die of 1.0, wherein the optical material has a nominal thickness ranging from about 5 to about 1000 microns.
1.12 The die of 1.0, wherein the substrate has a size ranging from about 50 mm x 50 mm to about 300 mm x 300 mm.
1.13 The die of 1.0, wherein the substrate has an aspect ratio ranging from about 1:1 to about 10:1.
1.14 The die of claim 1.8, wherein the two or more non-rectangular shapes, of the optical material, ranges from about 2 to about 10.
1.15 A wafer comprising: a plurality of dies of 1.0, wherein the plurality of dies share a common continuous surface of the substrate.
1.16 The wafer of claim 1.15, wherein the substrate is glass; and the optical material is chosen from a polymer and sol-gel.
1.17 The wafer of claim 1.15, wherein the plurality of dies are separated one from another by a dicing street.
1.18 A method of making a wafer, comprising: placing an optical material on a portion of a mold having a positive relief pattern to form a non-rectangular shape of optical material on each positive relief of the pattern; contacting a substrate with the optical material to provide a non-rectangular shaped to the optical material having a nominal thickness ranging from about 5 micron to about 1000 microns; and removing the mold.
1.19 The method of claim 1.18, wherein the step of placing the optical material includes controlling a droplet size of the optical material.
1.20 A method of making a die, comprising: providing the wafer of claim 1.18; and dicing the wafer between separate portions of the optical material.

From the foregoing description, those skilled in the art can appreciate that the present teachings can be implemented in a variety of forms. Therefore, while these teachings have been described in connection with particular embodiments and examples thereof, the true scope of the present teachings should not be so limited. Various changes and modifications can be made without departing from the scope of the teachings herein.

This scope disclosure is to be broadly construed. It is intended that this disclosure disclose equivalents, means, systems and methods to achieve the devices, activities and mechanical actions disclosed herein. For each device, article, method, mean, mechanical element or mechanism disclosed, it is intended that this disclosure also encompass in its disclosure and teaches equivalents, means, systems and methods for practicing the many aspects, mechanisms and devices disclosed herein. The claims of this application are likewise to be broadly construed. The description of the inventions herein in their many embodiments is merely exemplary in nature and, thus, variations that do not depart from the gist of the invention are intended to be within the scope of the invention. Such variations are not to be regarded as a departure from the spirit and scope of the invention.

## Claims

1. A die comprising:
a substrate having a surface defined by paired oppositely-oriented edges; and
an optical material, in a non-rectangular shape, on the surface of the substrate;
wherein the optical material does not extend an entire length of any one of the paired oppositely-oriented edges.

2. The die of claim 1, wherein the optical material, in the non-rectangular shape, has a planar bottom surface that interfaces with a top surface of the substrate; and
has one or more surfaces that, together with the planar bottom surface, form a three-dimensional shape selected from the group consisting of a pyramid, pentagon prism, hexagon prism, septagon prism, octagon prism, a half-sphere, cylinder, and cone.

3. The die of claim 1 or claim 2, wherein the non-rectangular shape of the optical material is a cylinder.

4. The die of claim 3, wherein a diameter of the cylinder is equal to a first dimension of the substrate.

5. The die of claim 3, wherein a diameter of the cylinder is less than a first dimension of the substrate.

6. The die of any preceding claim, wherein the optical material is a single non-rectangular shape on the surface of the substrate.

7. The die of any preceding claim, wherein the optical material is two or more non-rectangular shapes on the surface of the substrate, and the two or more non-rectangular shapes are separated one from another by a gap in the optical material.

8. The die of any preceding claim, wherein a portion, near an edge, of the top surface of the substrate is void of the optical material.

9. The die of any preceding claim, wherein the optical material has a non-uniform thickness.

10. The die of any preceding claim, wherein the optical material has a nominal thickness ranging from about 5 to about 1000 microns.

11. The die of any preceding claim, wherein the substrate has a size ranging from about 50 mm x 50 mm to about 300 mm x 300 mm.

12. The die of any preceding claim, wherein the substrate has an aspect ratio ranging from about 1:1 to about 10:1.

13. A wafer comprising:
a plurality of dies according to any one of claims 1 to 12,
wherein the plurality of dies share a common continuous surface of the substrate.

14. A method of making a wafer, comprising:
placing an optical material on a portion of a mold having a positive relief pattern to form a non-rectangular shape of optical material on each positive relief of the pattern;
contacting a substrate with the optical material to provide a non-rectangular shaped to the optical material having a nominal thickness ranging from about 5 micron to about 1000 microns; and
removing the mold.

15. A method of making a die, comprising:
providing the wafer of claim 13;
dicing the wafer between separate portions of the optical material.
